# EUROPEAN PATENT APPLICATION

(11) **EP 4 772 887 A1**
(43) Date of publication of application: **08.07.2026**
(21) Application number: 24859391.5
(22) Date of filing: 07.08.2024
(51) Int. Cl.: G01R 11/02

(54) **METHOD FOR MEASURING ELECTRICITY USAGE**

(30) Priority: 31.08.2023 JP 2023140833
(71) Applicant: Tokyo Facilities Co.,Ltd., Tokyo 143-0013 (JP)
(72) Inventor: NAKATANI, Hironobu, TOKYO 143-0013 (JP); INOUE, Masayoshi, TOKYO 143-0013 (JP); NAKATANI, Hisako, TOKYO 143-0013 (JP)
(74) Representative: Grünecker Patent- und Rechtsanwälte PartG mbB
(86) International application number: PCT/JP2024/028229
(87) International publication number: WO 2025/047351

(57) **Abstract**

Provided is a method for accurately measuring an amount of electric energy used by a consumer, in which an electricity meter is installed, using the electricity meter.

A method for measuring an amount of electric energy used includes installing a noise filter 3 in or near an electricity meter 1 that is connected to electric lines 2 for connecting a supplier supplying electricity and a consumer consuming the electricity to remove or reduce noise affecting the measurement of the amount of electric energy used by the electricity meter 1. When there are a plurality of the electric lines 2, the noise filter 3 is installed collectively for the plurality of electric lines 2. It is preferable to install the noise filters on both a supplier side and a consumer side with the electricity meter 1 as a boundary and to install a ferrite core 3 on the electric line 2.

## Description

### TECHNICAL FIELD

The present invention relates to a method for accurately measuring an amount of electric energy (electric energy usage or electric energy consumption) used by a consumer in which an electricity meter (a watt-hour meter or a watt meter) is installed, using the electricity meter.

### BACKGROUND ART

There are various types of electricity meters, such as mechanical electricity meters, electronic electricity meters, and smart meters. In any case, the electricity meter is connected to electric lines that connect a supplier, such as an electric power company, that supplies electricity and a consumer, such as a home, an office, or a factory, that consumes the electricity.

The above-described electricity meter has a problem in that it is not capable of accurately measuring the amount of electric energy used due to the influence of noise caused by electromagnetic waves or the like generated by the operation of various electrical appliances. In particular, in many cases, the electricity meter is installed outdoors. When an outdoor unit is installed near the electricity meter, there is a problem that electromagnetic waves generated by the outdoor unit due to the operation of a heating and cooling device cause errors in the measurement by the electricity meter.

Here, as the above-described noise, there are two types of noise: normal-mode noise and common-mode noise. First, the normal-mode noise is noise that travels in opposite directions between the positive and negative sides of a power supply and is a mode in which the noise returns to the power supply via a load. In contrast, the common-mode noise is noise that travels in the same direction on the positive and negative sides of the power supply and is a mode in which leaked noise returns to the power supply via the ground.

Therefore, a current input device has been proposed which converts an input current into a voltage using a shunt resistor and outputs the voltage, in order to remove the noise generated in the above-described electricity meter, and in which a ferrite core for removing common-mode noise included in the input current is provided in a fixed part for a path through which the input current flows before being converted into a voltage signal by the shunt resistor. The current input device is used for a current input portion of the electricity meter (see, for example, the following Patent Document 1).

In addition, a configuration has been proposed in which an electromagnetic wave absorber obtained by stacking a soft magnetic material that absorbs electromagnetic waves, a laminated member that shields electromagnetic waves in a frequency band higher than that of the soft magnetic material, and an adhesive material is installed in a distribution board or a panel board to suppress power consumption in homes and businesses (see, for example, the following Patent Document 2).

### CITATION LIST

### PATENT DOCUMENT

Patent Document 1: JP 2009-188320 A
Patent Document 2: JP 2018-156981 A

### DISCLOSURE OF THE INVENTION

### PROBLEM TO BE SOLVED BY THE INVENTION

However, the findings obtained by the inventors of the invention prove that the occurrence of the above-mentioned noise does not cause an increase in the amount of electric energy used, but instead hinders the electricity meter from accurately measuring the amount of electric energy used.

Accordingly, the problem to be solved by the invention is to provide a method that can accurately measure an amount of electric energy used using an electricity meter.

### MEANS FOR SOLVING PROBLEM

The invention has been proposed in order to solve the above problem and includes the following configurations. To assist in understanding the configurations of the invention, reference numerals and symbols shown in the drawings attached to this application are used in the following description.

According to Claim 1, there is provided a method for accurately measuring an amount of electric energy used by a consumer, in which an electricity meter (1) is installed, using the electricity meter (1). The method includes installing a noise filter (3) in or near the electricity meter (1) connected to electric lines (2) for connecting a supplier supplying electricity and the consumer consuming the electricity to remove or reduce noise affecting the measurement of the amount of electric energy used by the electricity meter (1). When there are a plurality of the electric lines (2), the noise filter (3) is installed collectively for the plurality of electric lines.

According to Claim 2, there is provided a method for accurately measuring an amount of electric energy used by a consumer, in which an electricity meter (1) is installed, using the electricity meter (1). The method includes installing a noise filter (3) in or near the electricity meter (1) connected to electric lines (2) for connecting a supplier supplying electricity and the consumer consuming the electricity to remove or reduce noise affecting the measurement of the amount of electric energy used by the electricity meter (1). The noise filters are installed on both a supplier side and a consumer side with the electricity meter (1) as a boundary.

According to Claim 3, in the method for measuring an amount of electric energy used according to Claim 1 or 2, a ferrite core (3) may be used as the noise filter (3).

According to Claim 4, in the method for measuring an amount of electric energy used according to Claim 3, a split-type ferrite core (3) may be used as the ferrite core (3).

### EFFECT OF THE INVENTION

The method for measuring an amount of electric energy used according to the invention can exhibit the following effects since it has the above-described configurations.

As described above, the findings obtained by the inventors of the invention prove that, while the occurrence of noise caused by electromagnetic waves and the like hinders the electricity meter from accurately measuring the amount of electric energy used, the noise filter (3) can be installed in or near the electricity meter (1) to remove or reduce the noise affecting the measurement of the amount of electric energy used by the electricity meter (1) in the method for measuring an amount of electric energy used according to Claim 1. Therefore, the method for measuring an amount of electric energy used according to Claim 1 can solve the problem to be solved by the invention which is to provide a method capable of accurately measuring an amount of electric energy used using an electricity meter.

In many cases, noise affecting the electricity meter (1) is transmitted through the electric line (2). Therefore, when the noise filter (3) is installed on the electric line (2) as in the method for measuring an amount of electric energy used according to Claim 1, it is possible to effectively remove or reduce noise affecting the measurement of the amount of electric energy used by the electricity meter (1).

Further, the findings obtained by the inventors of the invention prove that, when there are a plurality of electric lines (2), the noise filters (3) are installed individually for the plurality of electric lines (2) as in the method for measuring an amount of electric energy used according to Claim 1, which makes it possible to effectively remove or reduce normal-mode noise in particular.

Furthermore, the findings obtained by the inventors of the invention prove that, when there are a plurality of electric lines (2), the noise filter (3) is installed collectively for the plurality of electric lines (2) as in the method for measuring an amount of electric energy used according to Claim 1, which makes it possible to effectively remove or reduce common-mode noise in particular.

Here, the findings prove that, even when the noise filter (3) is installed on only one of the supplier side that supplies electricity and the consumer side that consumes the electricity with the electricity meter (1) as a boundary, it is possible to remove or reduce noise generated in the electricity meter (1) to some extent, but installing the noise filters (3) on both sides as in the method for measuring an amount of electric energy used according to Claim 2 makes it possible to more reliably remove or significantly reduce the noise.

In general, various known members, such as coils, capacitors, and ferrite cores, are used as the noise filter (3). From the viewpoint of ease of attachment to the electric line, it is preferable to use a ferrite core, particularly, a split-type ferrite core as in the method for measuring an amount of electric energy used according to Claim 3 or 4.

### BRIEF DESCRIPTION OF DRAWINGS

Fig. 1 is a schematic view showing a configuration of an embodiment of a method for measuring an amount of electric energy used according to the invention;
Fig. 2 is a schematic view showing a configuration of an embodiment of the method for measuring the amount of electric energy used according to the invention; and
Fig. 3 is a partially enlarged explanatory view of Fig 1.

### BEST MODE(S) FOR CARRYING OUT THE INVENTION

Hereinafter, a method for measuring an amount of electric energy used according to an embodiment of the invention will be described with reference to the accompanying drawings.

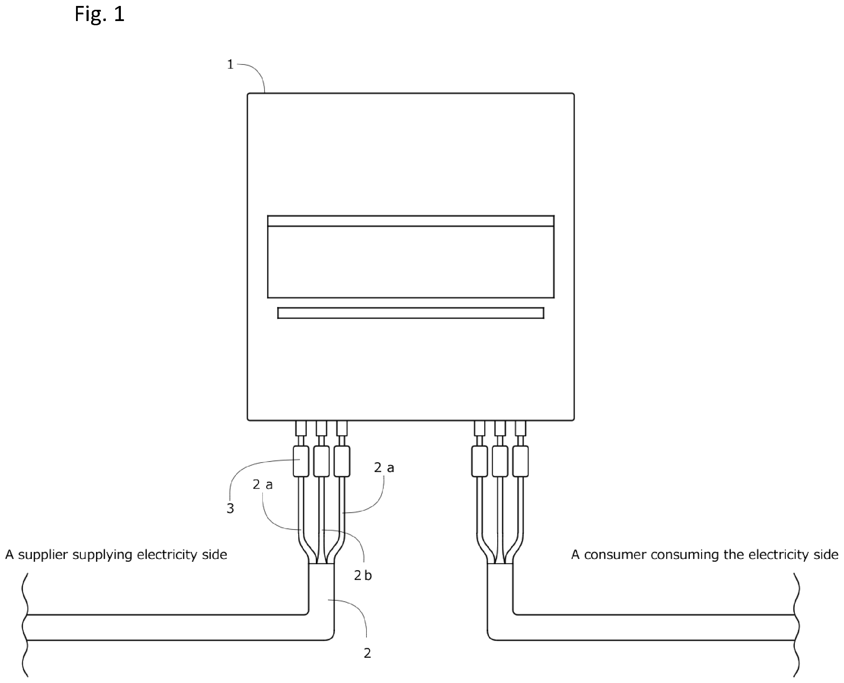

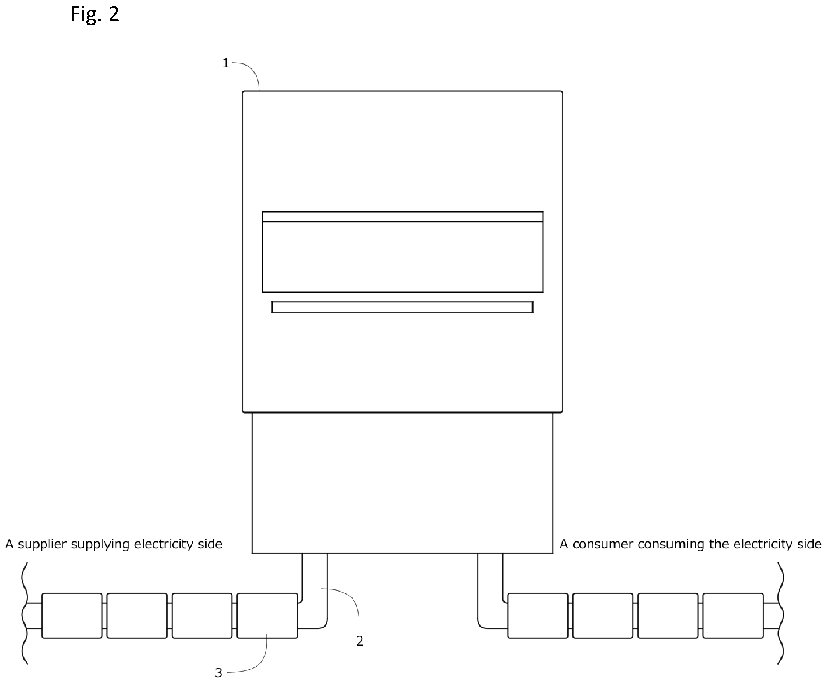

There are various types of electricity meters, such as mechanical electricity meters, electronic electricity meters, and smart meters. As shown in Figs. 1 and 2, in any case, the electricity meter is connected to electric lines (2) for connecting a supplier, such as an electric power company, that supplies electricity, and a consumer, such as a home, an office, or a factory, that consumes the electricity. In addition, the method for measuring the amount of electric energy used according to the invention can be implemented regardless of the type of electricity meter described above.

The method for measuring the amount of electric energy used according to the invention is a method for accurately measuring an amount of electric energy used by a consumer in which an electricity meter (1) is installed, using the electricity meter (1). The method includes installing a noise filter (3) in or near the electricity meter (1) connected to electric lines (2) for connecting a supplier that supplies electricity and the consumer that consumes the electricity to remove or reduce noise affecting the measurement of the amount of electric energy used by the electricity meter (1), as shown in Figs. 1 and 2.

The findings obtained by the inventors of the invention prove that, while the electricity meter (1) is hindered from accurately measuring the amount of electric energy used due to the influence of noise caused by electromagnetic waves or the like generated by the operation of various electrical appliances, the noise filter (3) can be installed in or near the electricity meter (1) to remove or reduce noise the affects the measurement of the amount of electric energy used by the electricity meter (1) according to the method for measuring the amount of electric energy used according to the invention.

In many cases, noise affecting the electricity meter (1) is transmitted through the electric lines (2). Therefore, when the noise filter (3) is installed on the electric line (2) as shown in Fig. 1, it is possible to effectively remove or reduce the noise affecting the measurement of the amount of electric energy used by the electricity meter (1). Further, in this case, it is preferable to install the noise filter (3) as close to the electricity meter (1) as possible. That is, the reason is that, even when the noise filter (3) is installed at a location away from the electricity meter (1), noise infiltrates the electric line (2) between the noise filter (3) and the electricity meter (1), is transmitted to the electricity meter (1), and affects the electricity meter (1).

The findings obtained by the inventors of the invention proved that, as shown in Fig. 1, when there were a plurality of electric lines (2), installing the noise filters (3) individually for each of the plurality of electric lines (2) made it possible to effectively remove or reduce normal-mode noise, in particular. Specifically, in the case of a single-phase three-wire distribution system which is currently the mainstream in ordinary households, the electric lines (2) are composed of two voltage lines (2a) on both sides and one neutral line (2b) interposed between the two voltage lines (2a), and the noise filters (3) are installed individually for the three electric lines. Of course, in the case of a single-phase two-wire distribution system, the electric lines are composed of one voltage line and one neutral line, and the noise filters are installed individually for the two electric lines.

Furthermore, the findings obtained by the inventors of the invention proved that, as shown in Fig. 2, when there were a plurality of electric lines (2), installing the noise filter (3) collectively for the plurality of electric lines (2) made it possible to effectively remove or reduce common-mode noise, in particular. Specifically, in the case of the single-phase three-wire distribution system, the electric lines (2) are composed of two voltage lines (2a) and one neutral line (2b) as described above, and the noise filter (3) is installed collectively for the three electric lines. Of course, in the case of the single-phase two-wire distribution system, the electric lines are composed of one voltage line and one neutral line, and the noise filter is installed collectively for the two electric lines.

Of course, as shown in Figs. 1 and 2, when there are a plurality of electric lines (2), the noise filters (3) may be installed individually for the plurality of electric lines (2), and the noise filter (3) may be installed collectively for the plurality of electric lines (2). In this case, it is possible to effectively remove or reduce both the normal-mode noise and the common-mode noise, which is preferable.

The findings obtained by the inventors of the invention prove that, even when the noise filter (3) is installed on only one of the supplier side that supplies electricity and the consumer side that consumes the electricity with the electricity meter (1) as a boundary, it is possible to remove or reduce the noise generated in the electricity meter (1) to some extent, but installing the noise filters (3) on both sides as shown in Figs. 1 and 2 makes it possible to more reliably remove or significantly reduce the noise. In addition, installing a larger number of noise filters (3) makes it possible to more reliably remove or more significantly reduce the noise generated in the electricity meter (1). One noise filter (3) is installed for each of the three electric lines (2) on both the supplier side and the consumer side, with the electricity meter (1) as a boundary in Fig 1, and four noise filters (3) are installed on each of the supplier side and the consumer side, with the electricity meter (1) as a boundary in Fig. 2. However, the number of noise filters is not particularly limited.

In general, various known members, such as coils, capacitors, and ferrite cores, are used as the noise filter. From the viewpoint of ease of attachment to the electric line (2), it is preferable to use a ferrite core (3) as the noise filter (3) used in the method for measuring the amount of electric energy used according to the invention, as shown in Figs 1 and 2.

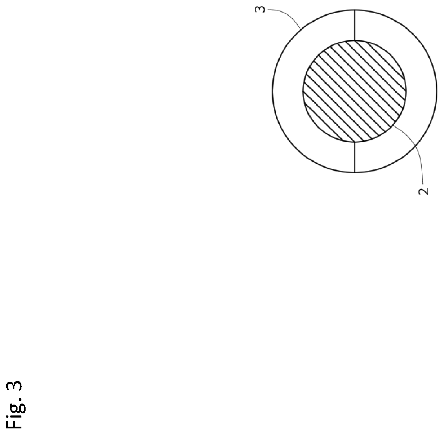

Here, various types of ferrite cores are provided. A ring-shaped ferrite core with an inner diameter that fits tightly around the electric line is used, which makes it possible to suppress the generation of magnetic flux and thus to more reliably remove noise or significantly reduce noise. However, this type of ferrite core is difficult to install on the electric line. Therefore, when a split-type ferrite core (3) shown in Fig. 3 is used, it is easy to install the ferrite core on the electric line (2). In addition, when there is a gap between the electric line (2) and the ferrite core (3), the electric line (2) may be wound around the ferrite core (3) to be in close contact with the ferrite core (3).

The inventors of the invention compared the numerical values indicated by the electricity meter as the amount of electric energy used in the same facility during the same season. The comparison results show that, as shown in the following Table 1, there is a significant difference between the measurement results of the amounts of electric energy used before and after the method for measuring the amount of electric energy used according to the invention is implemented.

**[Table 1]**

| Measurement Month | Amount of electric energy used displayed in electricity meter before the invention is implemented (kWh) | Amount of electric energy used displayed in electricity meter after the invention is implemented (kWh) | Reduction rate (%) |
|---|---|---|---|
| March | 557 | 469 | 29 |
| April | 388 | 281 | 28 |
| May | 232 | 183 | 21 |
| June | 190 | 156 | 18 |

### EXPLANATIONS OF LETTERS OR NUMERALS

- 1: ELECTRICITY METER
- 2: ELECTRIC LINE
- 2a: VOLTAGE LINE
- 2b: NEUTRAL LINE
- 3: NOISE FILTER (FERRITE CORE)

## Claims

1. A method for accurately measuring an amount of electric energy used by a consumer, in which an electricity meter is installed, using the electricity meter, the method comprising:
installing a noise filter in or near the electricity meter connected to electric lines for connecting a supplier supplying electricity and the consumer consuming the electricity to remove or reduce noise affecting the measurement of the amount of electric energy used by the electricity meter, and
wherein, when there are a plurality of the electric lines, the noise filter is installed collectively for the plurality of electric lines.

2. A method for accurately measuring an amount of electric energy used by a consumer, in which an electricity meter is installed, using the electricity meter, the method comprising:
installing a noise filter in or near the electricity meter connected to electric lines for connecting a supplier supplying electricity and the consumer consuming the electricity to remove or reduce noise affecting the measurement of the amount of electric energy used by the electricity meter,
wherein the noise filters are installed on both a supplier side and a consumer side with the electricity meter as a boundary.

3. The method for measuring an amount of electric energy used according to Claim 1 or 2,
wherein a ferrite core is used as the noise filter.

4. The method for measuring an amount of electric energy used according to Claim 3,
wherein a split-type ferrite core is used as the ferrite core.
